(19) Europäisches Patentamt
European Patent Office
Office européen des brevets

(11) **EP 2 762 904 A1**

(12) **EUROPEAN PATENT APPLICATION**
published in accordance with Art. 153(4) EPC

(43) Date of publication:
06.08.2014 Bulletin 2014/32

(51) Int Cl.:
*G01R 22/06* (2006.01)

(21) Application number: 11873445.8

(22) Date of filing: 18.10.2011

(86) International application number:
PCT/KR2011/007739

(87) International publication number:
WO 2013/047940 (04.04.2013 Gazette 2013/14)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR

(30) Priority: 26.09.2011 KR 20110097158

(71) Applicant: Korea Electric Power Corporation
Seoul 135-791 (KR)

(72) Inventors:
• KIM, Sang-Jun
Seoul 143-842 (KR)
• PARK, Sang-Suh
Seongnam-si
Gyeonggi-do 463-731 (KR)

• KIM, Dong-Sub
Seongnam-si
Gyeonggi-do 463-731 (KR)
• KIM, Su-Bong
Seongnam-si
Gyeonggi-do 463-400 (KR)
• YI, Jeong-Ryoul
Seoul 135-952 (KR)

(74) Representative: Ishiguro, Masaoki
IPecunia Patents B.V.
P.O. Box 593
6160 AN Geleen (NL)

(54) **ELECTRONIC POWER METER FOR DETECTING AN N PHASE CURRENT BASED ON WAVEFORM SUPERPOSITION OF A THREE PHASE INPUT CURRENT, AND N PHASE CURRENT DETECTING METHOD USING SAME**

(57) The present invention relates to an electronic power meter for detecting an N phase current based on waveform superposition of a three phase input current, and an N phase current detecting method using same. The electronic power meter comprises: a sampling unit for sampling a three phase input current and calculating sampled current values for each phase; and an N phase current calculating unit for receiving the sampled current values for each phase and calculating an N phase current using superposed results of the sampled values at an identical sampling time from among the sampled values for each phase over a unit of time.

FIG. 5

## Description

### Technical Field

The present invention relates to an electronic watt-hour meter for detecting N-phase current through the waveform superposition of input three-phase current and a method for detecting N-phase current using the electronic watt-hour meter and, more particularly, to an electronic watt-hour meter that samples input three-phase current and superposes the values at each same sampling time point among three-phase sampling current values during a unit time period, thereby detecting N-phase current, and a method that detects N-phase current using the electronic watt-hour meter.

This application claims the benefit of the filing date of Korean Patent Application No. 10-2011-0097158 filed on September 26, 2011, the entire content of which is incorporated herein by reference.

### Background Art

Conventionally, when an N-phase current value is required to detect the fault and short circuit of a three-phase electric system, N-phase current is calculated by detecting voltage and current analog signals input to a watt-hour meter, measuring power through the sequential sampling of the analog signals, calculating the root-mean-square value of respective phase currents, and obtaining phases from the calculated reactive and active power values of voltage and current during a specific period calculated using the root-mean-square value.

However, when N-phase current is calculated as described above, N-phase current should be calculated using the root-mean-square value of respective phase currents and an average phase during a specific period (for example, 60 cycles), so that a problem arises in that error range is increased and thus it is difficult to utilize a resulting value as data.

Meanwhile, in another method of calculating an N-phase current value, N-phase current may be calculated by calculating the root-mean-square value of respective phase currents and calculating the differences among the respective phases by using zero-crossing.

However, these methods of calculating N-phase current are problematic in that it is difficult to use them for general purposes because they are chiefly used to calculate respective phases, rather than calculating N-phase current, and are mainly used in expensive and precise measuring instruments guaranteeing high precision.

## Disclosure

### Technical Problem

An object of the present invention is to provide an electronic watt-hour meter that samples input three-phase current and superposes the values at each same sampling time point among three-phase sampling current values during a unit time period, thereby detecting N-phase current, and a method that detects N-phase current using the electronic watt-hour meter.

### Technical Solution

In order to accomplish the above object, in accordance with an embodiment of the present invention, there is provided an electronic watt-hour meter for detecting N-phase current, the electronic watt-hour meter including a sampling unit configured to calculate respective phase sampling current values by sampling input three-phase analog current; and an N-phase current calculation unit configured to receive the respective phase sampling current values, and to calculate N-phase current using results obtained by superposing the values at each same sampling time point among the respective phase sampling current values during a unit time period.

The N-phase current calculation unit may calculate N-phase sampling current values using results obtained by adding, in a superposed manner, the values of the respective phase sampling current values at the same sampling time point during the unit time period, and may calculate the N-phase current using a result obtained by calculating the root-mean-square value of the N-phase sampling current values.

The sampling unit may set sampling time in order to convert the input three-phase analog current into digital signals, and may calculate the respective phase sampling current values based on the set sampling time.

In order to accomplish the above object, in accordance with an embodiment of the present invention, there is provided a method of detecting N-phase current in an electronic watt-hour meter, the method including calculating respective phase sampling current values by sampling input three-phase analog current; and calculating N-phase current by superposing the values at each same sampling time point among the respective phase sampling current values during a unit time period.

Calculating the N-phase current may include calculating N-phase sampling current values using results obtained by adding, in a superposed manner, the values of the respective phase sampling current values at the same sampling time point during the unit time period; and calculating the N-phase current using a result obtained by calculating a root-mean-square value of the N-phase sampling current values.

Calculating the respective phase sampling current values may include receiving the input three-phase analog current; setting sampling time in order to sample the input three-phase analog current; and calculating the respective phase sampling current values based on the set sampling time.

**Advantageous Effects**

In an embodiment of the present invention, N-phase current is calculated by sampling input three-phase current and then calculating the root-mean-square value of results obtained by adding sampling current values at each same sampling time point during a unit time period in a superposed manner, so that zero-crossing used to calculate phases and additional processing used to correct the results of a root-mean-square value and phases can be omitted, unlike in conventional art, with the result that implementation can be made using an inexpensive metering chip and N-phase current can be faster and more accurately calculated and applied .

**Description of Drawings**

FIG. 1 is a diagram schematically illustrating a conventional electronic watt-hour meter for detecting N-phase current;
FIG. 2 is a diagram schematically illustrating an electronic watt-hour meter for detecting N-phase current according to an embodiment of the present invention;
FIG. 3 is a diagram illustrating an example of setting sampling time according to an embodiment of the present invention;
FIG. 4 is a diagram illustrating an example of calculating an N-phase sampling current value according to an embodiment of the present invention; and
FIG. 5 is a flowchart illustrating a method of detecting N-phase current in an electronic watt-hour meter according to an embodiment of the present invention.

**Mode for Invention**

The present invention will be described in detail below with reference to the accompanying drawings. Repeated descriptions and descriptions of known functions and configurations which have been deemed to make the gist of the present invention unnecessarily obscure will be omitted below. The embodiments of the present invention are intended to fully describe the present invention to a person having ordinary knowledge in the art to which the present invention pertains. Accordingly, the shapes, sizes, etc. of components in the drawings may be exaggerated to make the description clearer.

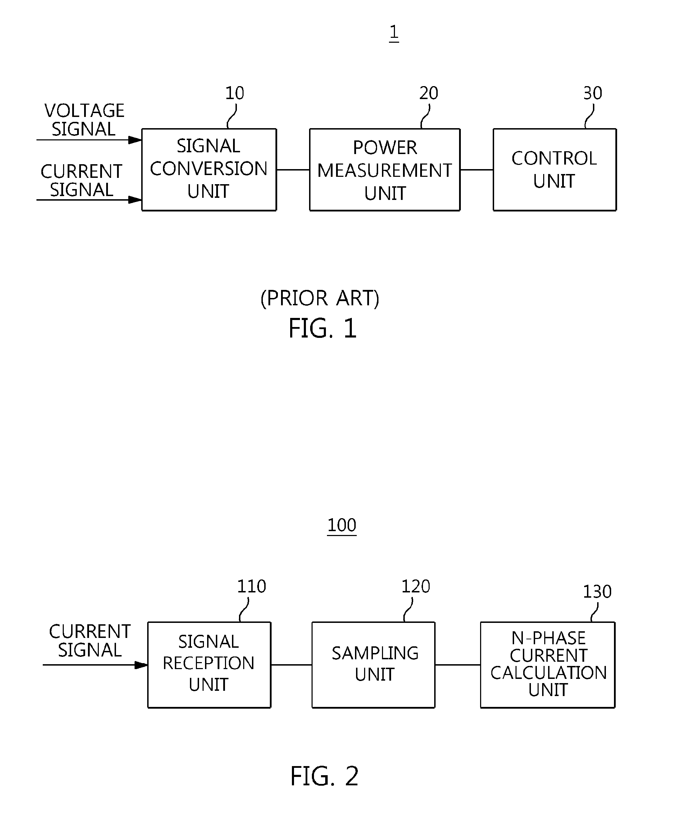

FIG. 1 is a diagram schematically illustrating a conventional electronic watt-hour meter for detecting N-phase current.

As illustrated in FIG. 1, a conventional electronic watt-hour meter 1 for detecting N-phase current includes a signal conversion unit 10, a power measurement unit 20, and a control unit 30.

The signal conversion unit 10 detects input three-phase analog voltage and current signals. Furthermore, the signal conversion unit 10 converts the detected analog voltage and current signals into digital signals by sequentially sampling and amplifying them, and transfers the amplified signals to the power measurement unit 20.

Then the power measurement unit 20 calculates power using the voltage and current signals converted into the digital signals, and transfers the calculated power and the voltage and current signals to the control unit 30.

The control unit 30 determines and stores transmission/reception active power, leading/lagging reactive power, a root-mean-square value during a specific period, a power factor value, or an event, such as an event regarding whether electric conduction is possible, using the voltage and current signals and the power. Furthermore, the control unit 30 calculates phases based on the calculated values of active and reactive power obtained in the same period, and calculates N-phase current using the phases.

However, since N-phase current should be calculated using the root-mean-square value of respective phase currents and an average phase during a specific period, a problem arises in that error range is increased and thus it is difficult to utilize a resulting value as data.

An electronic watt-hour meter for detecting N-phase current according to an embodiment of the present invention, which is provided to the above problem, will be described in greater detail below with reference to FIGS. 2 to 5.

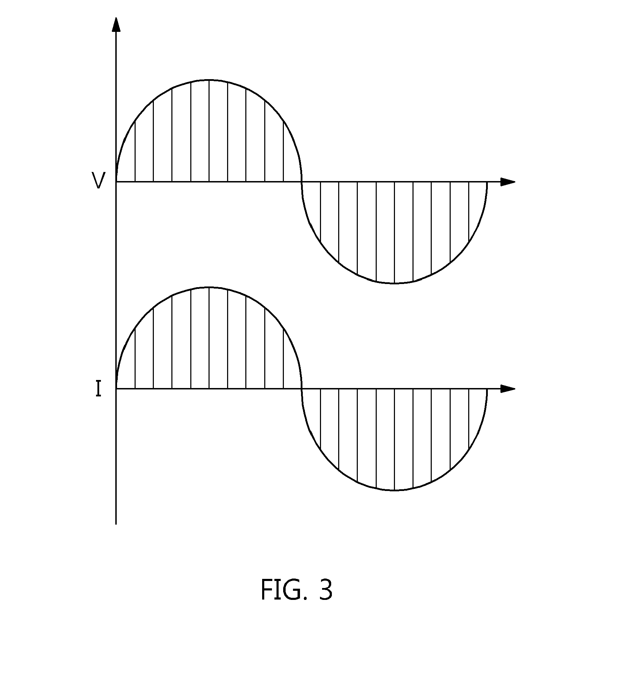

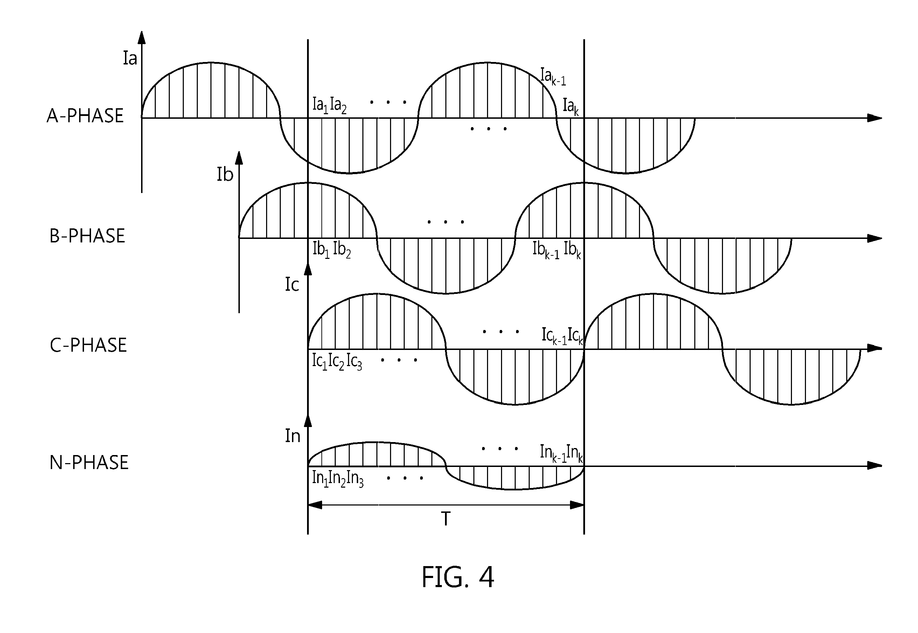

FIG. 2 is a diagram schematically illustrating an electronic watt-hour meter for detecting N-phase current according to an embodiment of the present invention. FIG. 3 is a diagram illustrating an example of setting sampling time according to an embodiment of the present invention. FIG. 4 is a diagram illustrating an example of calculating an N-phase sampling current value according to an embodiment of the present invention.

As illustrated in FIG. 2, the electronic watt-hour meter 100 for detecting N-phase current according to this embodiment of the present invention may be a smart meter, and includes a signal reception unit 110, a sampling unit 120, an N-phase current calculation unit 130, and a fault detection unit 140.

The signal reception unit 110 receives three-phase (A-phase, B-phase, and B-phase) input analog current, and transfers it to the sampling unit 120.

The sampling unit 120 includes an A/D converter (not illustrated), and sets sampling time (hereinafter interchangeable with the "sampling interval") in order to convert the respective phase analog current into digital signals, an example of which is illustrated in FIG. 3. In this case, the sampling time is set such that sampling intervals are appropriately set by considering the operation of the electronic watt-hour meter because the accuracy of the calculation of a resulting value increases in proportion to the number of sampling intervals during a unit time period but this influences operating performance, thereby consuming a large amount of power. The sampling unit 120 converts the respective phase analog current into digital signals based on the set sampling time.

The N-phase current calculation unit 130 receives the respective phase sampling current values Ia, Ib and Ic (hereafter also referred to as the "sampling current value") from the sampling unit 120. Furthermore, the N-phase current calculation unit 130 adds the values at each same sampling time point among the respective phase sampling current values during a unit time period, for example, during a single period T.

More specifically, the N-phase current calculation unit 130 calculates a first N-phase sampling current value $In_1$ by adding a first A-phase sampling current value $Ia_1$, a first B-phase sampling current value $Ib_1$, and a first C-phase sampling current value $Ic_1$ in a superposed manner during a single period T, as illustrated in FIG. 4. In this case, it is assumed that the number of respective-phase samplings is k during a single period T.

Furthermore, the N-phase current calculation unit 130 calculates a second N-phase sampling current value $In_2$ by adding a second A-phase sampling current value $Ia_2$, a second B-phase sampling current value $Ib_2$, and a second C-phase sampling current value $Ic_2$ in a superposed manner.

Likewise, the N-phase current calculation unit 130 calculates a k-th N-phase sampling current value $In_k$ by adding a k-th A-phase sampling current value $Ia_k$, a k-th B-phase sampling current value $Ib_k$, and a k-th C-phase sampling current value $Ic_k$ in a superposed manner during a last sampling interval.

Once the N-phase sampling current values $In_1$, $In_2$, $In_3$, ..., and $In_k$ have been obtained by adding the respective-phase (A-phase, B-phase and C-phase) sampling current values at each same sampling time point as described above, the N-phase current calculation unit 130 calculates an N-phase current value In by calculating an N-phase current root-mean-square value using the obtained N-phase sampling current values $In_1$, $In_2$, $In_3$, ..., and $In_k$, as described in Equation 1:

$$I_n = \sqrt{(I_{n1}^2 + I_{n2}^2 + \cdots + I_{nk}^2)/k} \qquad (1)$$

where $In_1$ ($Ia_1+Ib_1+Ic_1$) is the first N-phase sampling current value, $In_2$ ($Ia_2+Ib_2+Ic_2$) is the second N-phase sampling current value, ..., and $In_k$ ($Ia_k+Ib_k+Ic_k$) is a k-th N-phase sampling current value.

In other words, to calculate N-phase current, this embodiment of the present invention is configured to calculate the N-phase current by calculating the root-mean-square value of the results obtained by adding a number of respective phase sampling current values equal to the predetermined number of samplings during a predetermined unit time period, rather than calculating phases, as in conventional art.

If an A/D converter for performing respective phase sampling in order to calculate N-phase current in the above-described manner can perform only sampling at the same sampling time point, N-phase current can be more simply calculated.

Furthermore, when the load current is lower than 10% of a rated current, the error range of the current measurement current transformer of the electronic watt-hour meter is increased twice. If, in order to mitigate the error range, a case where the load current is lower than 10% and a case where the error range is equal to or higher than 10% are identified and then N-phase current values are calculated in connection with these cases, the reliability of N-phase current data can be further improved.

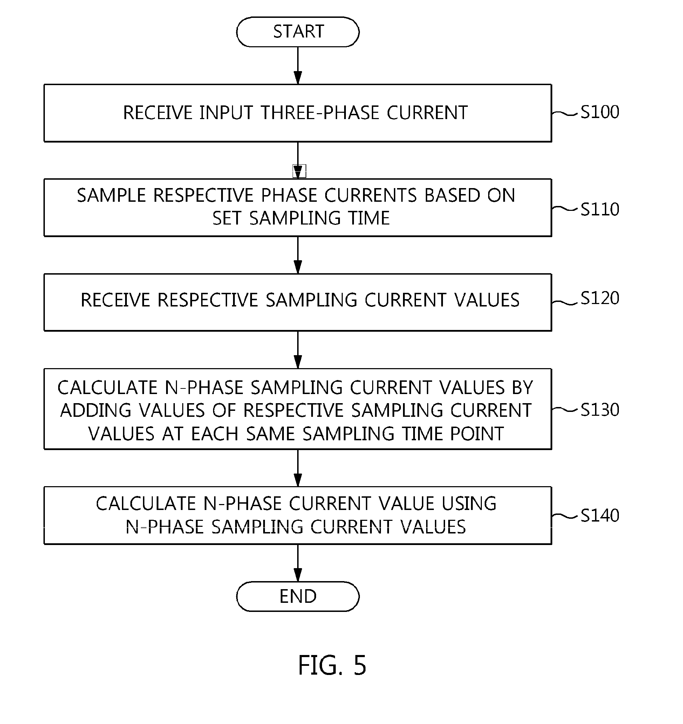

FIG. 5 is a flowchart illustrating a method of detecting N-phase current in an electronic watt-hour meter according to an embodiment of the present invention.

As illustrated in FIG. 5, the signal reception unit 110 of the electronic watt-hour meter 100 according to the embodiment of the present invention receives three-phase (A-phase, B-phase and C-phase) input analog voltage and current and transfers them to the sampling unit 120 at step S 100.

The sampling unit 120 converts the respective phase analog voltage and current into digital signals based on set sampling time at step S110.

Then the N-phase current calculation unit 130 receives respective phase sampling current values from the sampling unit 120 at step S120. Furthermore, the N-phase current calculation unit 130 calculates N-phase sampling current values $In_1$, $In_2$, $In_3$, ..., and $In_k$ by adding the values at each same sampling time point among the respective phase sampling current values during a unit time period, for example, during a single period T, at step S 130.

The N-phase current calculation unit 130 calculates an N-phase current value In by calculating an N-phase current root-mean-square value using the obtained N-phase sampling current values $In_1$, $In_2$, $In_3$, ..., and $In_k$, as described in Equation 1, at step S140.

As described above, in an embodiment of the present invention, N-phase current is calculated by sampling input three-phase current and then calculating the root-mean-square value of results obtained by adding sampling current values at each same sampling time point during a unit time period in a superposed manner, so that zero-crossing used to calculate phases and additional processing used to correct the results of a root-mean-square value and phases can be omitted, unlike in conventional art, with the result that implementation can be made using an inexpensive metering chip and N-phase current can be faster and more accurately calculated and applied .

As described above, the optimum embodiments have been disclosed in the drawings and the specification. Although the specific terms have been used herein, they have been used merely for the purpose of describing the present invention, and have not been used to limit the meanings thereof and the scope of the present invention set forth in the claims. Therefore, it will be understood by those having ordinary knowledge in the art that various modifications and other equivalent embodiments can be made. As a result, the technical range of the protections of the present invention should be defined by the technical spirit of the attached claims.

**Claims**

1. An electronic watt-hour meter for detecting N-phase current, the electronic watt-hour meter comprising:

   a sampling unit configured to calculate respective phase sampling current values by sampling input three-phase analog current; and
   an N-phase current calculation unit configured to receive the respective phase sampling current values, and to calculate N-phase current using results obtained by superposing values at each same sampling time point among the respective phase sampling current values during a unit time period.

2. The electronic watt-hour meter of claim 1, wherein the N-phase current calculation unit calculates N-phase sampling current values using results obtained by adding, in a superposed manner, the values of the respective phase sampling current values at the same sampling time point during the unit time period, and calculates the N-phase current using a result obtained by calculating a root-mean-square value of the N-phase sampling current values.

3. The electronic watt-hour meter of claim 1, wherein the sampling unit sets sampling time in order to convert the input three-phase analog current into digital signals, and calculates the respective phase sampling current values based on the set sampling time.

4. A method of detecting N-phase current in an electronic watt-hour meter, the method comprising:

   calculating respective phase sampling current values by sampling input three-phase analog current; and
   calculating N-phase current by superposing values at each same sampling time point among the respective phase sampling current values during a unit time period.

5. The method of claim 4, wherein calculating the N-phase current comprises:

   calculating N-phase sampling current values using results obtained by adding, in a superposed manner, the values of the respective phase sampling current values at the same sampling time point during the unit time period; and
   calculating the N-phase current using a result obtained by calculating a root-mean-square value of the N-phase sampling current values.

**6.** The method of claim 4, wherein calculating the respective phase sampling current values comprises:

receiving the input three-phase analog current;
setting sampling time in order to sample the input three-phase analog current; and
calculating the respective phase sampling current values based on the set sampling time.

<u>1</u>

VOLTAGE
SIGNAL

CURRENT
SIGNAL

10
SIGNAL
CONVERSION
UNIT

20
POWER
MEASUREMENT
UNIT

30
CONTROL
UNIT

(PRIOR ART)
FIG. 1

<u>100</u>

CURRENT
SIGNAL

110
SIGNAL
RECEPTION
UNIT

120
SAMPLING
UNIT

130
N-PHASE
CURRENT
CALCULATION
UNIT

FIG. 2

FIG. 3

FIG. 4

EP 2 762 904 A1

START

RECEIVE INPUT THREE-PHASE CURRENT — S100

SAMPLE RESPECTIVE PHASE CURRENTS BASED ON
SET SAMPLING TIME — S110

RECEIVE RESPECTIVE SAMPLING CURRENT VALUES — S120

CALCULATE N-PHASE SAMPLING CURRENT VALUES BY
ADDING VALUES OF RESPECTIVE SAMPLING CURRENT
VALUES AT EACH SAME SAMPLING TIME POINT — S130

CALCULATE N-PHASE CURRENT VALUE USING
N-PHASE SAMPLING CURRENT VALUES — S140

END

FIG. 5

**EP 2 762 904 A1**

## INTERNATIONAL SEARCH REPORT

International application No.

**PCT/KR2011/007739**

| A. CLASSIFICATION OF SUBJECT MATTER |
|---|
| ***G01R 22/06(2006.01)i*** |
| According to International Patent Classification (IPC) or to both national classification and IPC |

| B. FIELDS SEARCHED |
|---|
| Minimum documentation searched (classification system followed by classification symbols)<br>G01R 22/06; G01R 21/133; G01R 29/26; H02P 27/04; G01R 19/00; G01R 11/32; G01R 31/34; H02P 21/00 |
| Documentation searched other than minimum documentation to the extent that such documents are included in the fields searched<br>Korean Utility models and applications for Utility models: IPC as above<br>Japanese Utility models and applications for Utility models: IPC as above |
| Electronic data base consulted during the international search (name of data base and, where practicable, search terms used)<br>eKOMPASS (KIPO internal) & Keywords: 3 phase, N phase, superposition of waveform |

| C. DOCUMENTS CONSIDERED TO BE RELEVANT |
|---|

| Category* | Citation of document, with indication, where appropriate, of the relevant passages | Relevant to claim No. |
|---|---|---|
| A | JP 2000-329803 A (YOKOGAWA ELECTRIC CORPORATION) 30 November 2000<br>Abstract, page 3, claims 1,2 | 1-6 |
| A | KR 20-0397632 Y1 (LIM, TAEK - JAE) 06 October 2005<br>Abstract, claim 1, figure 1 | 1-6 |
| A | KR 10-2006-0006641 A (LSIS CO., LTD.) 19 January 2006<br>Abstract, claims 1-3 | 1-6 |
| A | KR 10-2011-0086263 A (KOREA PLANT SERVICE & ENGINEERING CO., LTD.) 28 July 2011<br>Abstract, claims 1-5, figures 3,5 | 1-6 |

☐ Further documents are listed in the continuation of Box C.  ☒ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 22 OCTOBER 2012 (22.10.2012) | **23 OCTOBER 2012 (23.10.2012)** |

| Name and mailing address of the ISA/KR | Authorized officer |
|---|---|
| Korean Intellectual Property Office<br>Government Complex-Daejeon, 139 Seonsa-ro, Daejeon 302-701, Republic of Korea<br>Facsimile No. 82-42-472-7140 | Telephone No. |

Form PCT/ISA/210 (second sheet) (July 2009)

INTERNATIONAL SEARCH REPORT
Information on patent family members

International application No.

**PCT/KR2011/007739**

| Patent document cited in search report | Publication date | Patent family member | Publication date |
|---|---|---|---|
| JP 2000-329803 A | 30.11.2000 | JP 3491676 B2 | 26.01.2004 |
| KR 20-0397632 Y1 | 06.10.2005 | NONE | |
| KR 10-2006-0006641 A | 19.01.2006 | NONE | |
| KR 10-2011-0086263 A | 28.07.2011 | NONE | |

Form PCT/ISA/210 (patent family annex) (July 2009)

**EP 2 762 904 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020110097158